(19) **Europäisches Patentamt**
**European Patent Office**
**Office européen des brevets**

(11) **EP 4 134 695 B1**

(12) **FASCICULE DE BREVET EUROPEEN**

(45) Date de publication et mention
de la délivrance du brevet:
**09.08.2023   Bulletin 2023/32**

(21) Numéro de dépôt: **22187670.9**

(22) Date de dépôt: **28.07.2022**

(51) Classification Internationale des Brevets (IPC):
**G01R 35/04** *(2006.01)*       **G01R 22/06** *(2006.01)*

(52) Classification Coopérative des Brevets (CPC):
**G01R 35/04;** G01R 22/068

(54) **VERIFICATION DE LA PRECISION METROLOGIQUE D'UN COMPTEUR ELECTRIQUE**

ÜBERPRÜFUNG DER METROLOGISCHEN PRÄZISION EINES STROMZÄHLERS

VERIFICATION OF THE METROLOGICAL PRECISION OF AN ELECTRICITY METER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.08.2021   FR 2108625**

(43) Date de publication de la demande:
**15.02.2023   Bulletin 2023/07**

(73) Titulaire: **Sagemcom Energy & Telecom SAS
92500 Rueil-Malmaison (FR)**

(72) Inventeurs:
• **TEBOULLE, Henri
92500 RUEIL MALMAISON (FR)**
• **GEHENIAU, Frédéric
92500 RUEIL MALMAISON (FR)**

(74) Mandataire: **Lavaud, Thomas
Cabinet Boettcher
5, rue de Vienne
75008 Paris (FR)**

(56) Documents cités:
**EP-B1- 0 092 303      EP-B1- 2 904 410
WO-A1-2014/027318**

**Description**

L'invention concerne le domaine des compteurs électriques.

ARRIERE PLAN DE L'INVENTION

La dérive de la précision métrologique, au cours de la vie d'un compteur électrique, peut avoir pour conséquence une surévaluation ou une sous-évaluation significative de la consommation d'énergie électrique.

La surévaluation est pénalisante pour l'abonné, alors que la sous-évaluation est pénalisante pour le distributeur d'énergie (en particulier lorsqu'un grand nombre de compteurs subissent une telle dérive).

La dérive de la précision métrologique est très difficile à détecter lorsqu'elle est lente et que les mesures produites demeurent crédibles bien qu'erronées.

Comme il serait très compliqué et très onéreux de faire intervenir des opérateurs régulièrement et systématiquement pour vérifier la précision métrologique de tous les compteurs électriques, on tente de développer des compteurs capables de vérifier de manière autonome leur précision. Les compteurs évaluent l'erreur de précision métrologique et, lorsque celle-ci ne se trouve pas dans la plage de précision requise, produisent et émettent un message d'alarme à destination (par exemple) du Système d'Information (SI) du distributeur d'énergie.

On connaît ainsi des compteurs équipés d'un circuit de mesure dont la fonction primaire est de mesurer l'énergie consommée par une installation, et qui réalise également une automesure de vérification métrologique. Le circuit de mesure intègre un générateur de courant pour injecter un courant de test en amont du compteur.

Cette solution ne fonctionne que pour de faibles courants de phase. Par ailleurs, le courant de test est en général injecté à une fréquence différente de la fréquence du réseau de distribution, ce qui nécessite un filtrage pour séparer l'énergie normalement reçue par le compteur de l'énergie injectée. Cette solution est donc à la fois complexe à concevoir et relativement onéreuse. Des compteurs électriques similaires sont divulgués par EP 2 904 410 B1, EP 0 092 303 B1 et WO 2014/027318 A1.

OBJET DE L'INVENTION

L'invention a pour objet une solution permettant à un compteur électrique d'estimer sa propre erreur de mesure de manière fiable, simple et peu coûteuse, et pouvant être mise en oeuvre quel que soit le niveau du courant de phase.

RESUME DE L'INVENTION

En vue de la réalisation de ce but, on propose un compteur électrique agencé pour mesurer une énergie consommée fournie à une installation par un réseau de distribution comprenant une phase et un neutre, le compteur électrique comportant :

- un conducteur de phase et un conducteur de neutre agencés pour être reliés respectivement à la phase et au neutre ;
- un circuit de test comprenant un composant de test et un composant de connexion agencé pour placer sélectivement le composant de test dans une configuration de connexion, dans laquelle le composant de test est connecté au conducteur de phase et au conducteur de neutre parallèlement à l'installation, de manière à former une charge additionnelle, et une configuration de déconnexion, dans laquelle le composant de test est déconnecté du conducteur de phase et/ou du conducteur de neutre ;
- un composant de traitement agencé pour piloter le composant de connexion de sorte que celui-ci place le composant de test dans la configuration de connexion pendant une durée de test prédéterminée, pour mesurer un surplus d'énergie consommé pendant la durée de test prédéterminée et dû à la charge additionnelle, et pour estimer une erreur de mesure du compteur électrique à partir du surplus d'énergie.

L'évaluation de l'erreur de mesure, réalisée par le compteur électrique selon l'invention, consiste à dériver un courant interne au compteur électrique par l'ajout temporisé d'une charge interne contrôlable.

Le compteur électrique selon l'invention évalue donc sa propre erreur de mesure sans utiliser de générateur de courant, et sans utiliser de filtrage complexe. Le circuit de test est simple à mettre en oeuvre et peu coûteux.

L'évaluation de l'erreur de mesure est très précise et très fiable (sans faux positifs), et peut être mise en oeuvre quel que soit le niveau du courant de phase.

L'invention sera mieux comprise à la lumière de la description qui suit de modes de mise en oeuvre particuliers non limitatifs de l'invention.

BREVE DESCRIPTION DES DESSINS

Il sera fait référence aux dessins annexés parmi lesquels :

[Fig. 1] la figure 1 représente un compteur électrique selon un premier mode de réalisation de l'invention, le compteur étant un compteur monophasé ;
[Fig. 2] la figure 2 représente des étapes d'un procédé d'évaluation de l'erreur de mesure du compteur ;
[Fig. 3] la figure 3 représente un compteur électrique selon un deuxième mode de réalisation de l'invention, le compteur étant un compteur monophasé ;
[Fig. 4] la figure 4 représente un compteur électrique selon un troisième mode de réalisation de l'invention, le compteur étant un compteur triphasé ;

[Fig. 5] la figure 5 représente un compteur électrique selon un quatrième mode de réalisation de l'invention, le compteur étant un compteur triphasé.

## DESCRIPTION DETAILLEE DE L'INVENTION

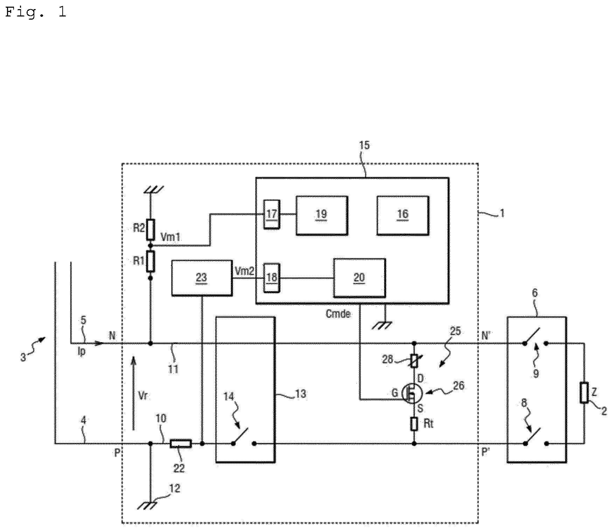

En référence à la figure 1, le compteur électrique selon un premier mode de réalisation de l'invention 1 est un compteur monophasé, qui est destiné à mesurer une énergie consommée fournie à l'installation électrique 2 d'un abonné par un réseau de distribution 3. L'installation électrique 2 est symbolisée par une charge Z.

Le réseau de distribution 3 comprend une phase 4 et un neutre 5.

Un disjoncteur 6 est positionné entre le compteur 1 et l'installation 2. Le disjoncteur 6, qui peut être actionné par l'abonné, a notamment pour rôle de protéger l'installation 2 en s'ouvrant lorsqu'un sur-courant, résultant par exemple d'un court-circuit en aval du disjoncteur 6, survient sur le réseau de distribution 3.

Le compteur 1 comprend un port de phase amont P relié à la phase 4 et un port de neutre amont N relié au neutre 5. Le compteur 1 comporte de plus un port de phase aval P' et un port de neutre aval N'.

Ici, par « en amont », on entend du côté du réseau de distribution 3, et par « en aval », on entend du côté de l'installation 2.

Le port de phase aval P' et le port de neutre aval N' du compteur 1 sont reliés à l'installation 2 respectivement via un interrupteur 8 et un interrupteur 9 intégrés dans le disjoncteur 6.

Le compteur 1 comporte de plus un conducteur de phase 10 relié à la phase 4 du réseau de distribution 3 via le port de phase amont P et un conducteur de neutre 11 relié au neutre 5 via le port de neutre amont N. Le compteur 1 comprend une masse électrique 12 reliée au conducteur de phase 10 à proximité du port de phase amont P.

Le compteur 1 comprend de plus un organe de coupure 13 comprenant un interrupteur 14 monté sur le conducteur de phase 10. L'organe de coupure 13 est notamment utilisé pour couper ou rétablir à distance l'alimentation de l'installation 2 en cas, par exemple, de résiliation de l'abonnement ou de non-respect du contrat d'abonnement.

Le compteur 1 comprend de plus des composants métrologiques.

Les composants métrologiques comprennent un composant de traitement, en l'occurrence un microcontrôleur de métrologie 15, dont la fonction primaire est de produire des mesures d'un certain nombre de paramètres permettant d'évaluer la consommation électrique de l'installation 2. Le microcontrôleur 15 produit des mesures d'un courant de phase Ip circulant sur la phase 4 du réseau de distribution 3, d'une tension réseau Vr entre la phase 4 et le neutre 5 du réseau de distribution 3 (et donc ici entre la masse électrique 12 du compteur 1 et le conducteur de neutre 11), ainsi que des mesures de puissance et d'énergie consommées par l'installation 2. La valeur efficace de la tension réseau Vr est théoriquement égale à 230V.

Le microcontrôleur 15 est de plus adapté à exécuter des instructions d'un programme pour mettre en oeuvre le procédé d'évaluation de l'erreur de mesure qui va être décrit. Le programme est stocké dans une mémoire 16, qui est intégrée dans ou reliée au microcontrôleur 15.

Le microcontrôleur 15 intègre un premier convertisseur analogique numérique (CAN) 17, un deuxième CAN 18, un module de mesure de tension 19 et un module de mesure de courant 20.

Les composants métrologiques comprennent aussi un pont diviseur de tension comprenant une première résistance de mesure R1 et une deuxième résistance de mesure R2. La première résistance de mesure R1 comprend une première borne reliée au conducteur de neutre 11. La deuxième résistance de mesure R2 comprend une première borne reliée à la masse électrique 12. La deuxième borne de la première résistance de mesure R1 et la deuxième borne de la deuxième résistance de mesure R2 sont reliées entre elles et à une entrée du microcontrôleur 15 à laquelle est reliée une entrée du premier CAN 17.

La tension Vm1, qui est mesurée par le premier CAN 17, est une tension image de la tension réseau Vr.

Le niveau de la tension Vm1 est adapté (grâce au pont diviseur R1, R2) afin d'éviter des saturations au niveau du premier CAN 17, et de manière à appliquer en entrée du premier CAN 17 des signaux ayant des niveaux significatifs (et correspondant à la plage d'entrée du premier CAN 17).

Le premier CAN 17 numérise donc la tension Vm1. Le module de mesure de tension 19 produit, à partir des échantillons produits par le premier CAN 17, des mesures de valeur efficace de la tension réseau Vr.

Les composants métrologiques comprennent aussi un capteur de courant, un *shunt* 22 en l'occurrence, monté sur le conducteur de phase 10 en amont de l'organe de coupure 13, ainsi qu'une chaîne de mesure de courant 23 présentant un gain connu. La chaîne de mesure de courant 23 est reliée à une borne du *shunt* 22 en aval de celui-ci. La tension aux bornes du *shunt* 22 est ainsi appliquée en entrée de la chaîne de mesure de courant 23.

La sortie de la chaîne de mesure de courant 23 est reliée à une entrée du microcontrôleur 15 à laquelle est reliée une entrée du deuxième CAN 18.

La tension Vm2 en sortie de la chaîne de mesure de courant 23 est une tension image du courant de phase Ip.

Le niveau de la tension Vm2 est adapté (grâce au gain de la chaîne de mesure de courant 23) afin d'éviter des saturations au niveau du deuxième CAN 18, et de manière à appliquer en entrée du deuxième CAN 18 des signaux ayant des niveaux significatifs (et correspondant à la plage d'entrée du deuxième CAN 18).

Le deuxième CAN 18 numérise la tension Vm2. Le module de mesure de courant 20 produit, à partir des échantillons produits par le deuxième CAN 18, des mesures du courant de phase Ip.

Le compteur 1 comporte de plus un circuit de test 25 comprenant un composant de test et un composant de connexion.

Le composant de test est ici une résistance de test Rt comprenant une première borne reliée à un premier conducteur parmi le conducteur de phase 10 et le conducteur de neutre 11. Le premier conducteur est ici le conducteur de phase 10.

Le composant de connexion a la fonction d'un interrupteur. Le composant de connexion est en l'occurrence un transistor MOSFET 26. Le transistor 26 comprend une première borne reliée à une deuxième borne de la résistance de test Rt et une deuxième borne reliée à un deuxième conducteur parmi le conducteur de phase 10 et le conducteur de neutre 11. Le deuxième conducteur est le conducteur de neutre 11.

La première borne du transistor 26 est sa source S alors que la deuxième borne du transistor 26 est son drain D.

La troisième borne du transistor 26, c'est-à-dire sa grille G, est reliée à une sortie du microcontrôleur 15.

Le microcontrôleur 15 peut commander le transistor en produisant une commande Cmde qu'il applique sur la grille G du transistor 26.

Le transistor 26 est commandable pour être passant ou bloqué, et peut donc placer sélectivement la résistance de test Rt dans une configuration de connexion ou de déconnexion. Dans la configuration de connexion, la résistance de test Rt est connectée au conducteur de phase 10 et au conducteur de neutre 11 parallèlement à l'installation 2, de manière à former une charge additionnelle s'ajoutant à la charge Z de l'installation 2. Dans la configuration de déconnexion, la résistance de test Rt est déconnectée du conducteur de phase 10 et/ou du conducteur de neutre 11 (en l'occurrence du conducteur de neutre 11).

Le transistor 26, qui est normalement bloqué, est commandé par la commande Cmde du microcontrôleur 15. Si la commande Cmde est un niveau de tension haut, le transistor 26 est passant. Si la commande Cmde est un niveau de tension bas, le transistor 26 est bloqué.

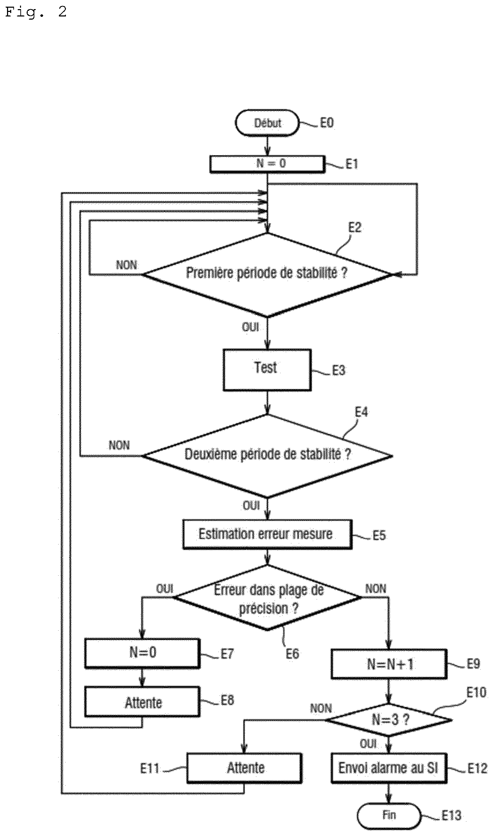

On décrit maintenant, en référence à la figure 2, la manière dont le compteur 1 estime l'erreur de mesure.

Le procédé d'évaluation, qui est mis en oeuvre par le microcontrôleur 15, démarre à l'étape E0.

La variable N est initialisée à 0 (étape E1).

La variable N permet de compter le nombre de fois successives où l'erreur de précision est mesurée hors gabarit acceptable.

Le procédé passe à l'étape E2. Le microcontrôleur 15 tente de détecter une première période de stabilité d'une première durée prédéterminée de l'énergie consommée et de la tension réseau Vr.

La première durée prédéterminée est ici égale à 3 secondes (consécutives).

Le microcontrôleur 15 tente donc de détecter une période de 3 secondes au cours de laquelle l'énergie consommée et la tension réseau Vr sont stables. Ici, par « grandeur stable au cours d'une période », on entend que la grandeur varie de ±0,1% maximum au cours de ladite période.

Tant qu'une première période de stabilité complète n'a pas été détectée, le procédé reste à l'étape E2.

Si la première période de stabilité a été détectée, le microcontrôleur 15, à l'issue de la première période de stabilité, c'est-à-dire au début de la quatrième seconde suivant le début de la première période de stabilité, commande le transistor 26 de sorte que celui-ci place la résistance de test Rt dans la configuration de connexion pendant une durée de test prédéterminée (étape E3).

La durée de test prédéterminée est ici égale à 1 seconde.

Le microcontrôleur 15 mesure alors l'énergie totale consommée pendant la durée de test prédéterminée.

L'énergie totale Et est telle que :

$$Et = E + Ec.$$

E correspond à l'énergie consommée « de base », c'est-à-dire au niveau de stabilité mesuré au cours de la première période de stabilité. Ec est le surplus d'énergie consommé pendant la durée de test prédéterminée et dû à la charge additionnelle (résistance de test Rt).

Le microcontrôleur 15 vérifie que la tension réseau Vr est stable pendant la quatrième seconde (durée de test prédéterminée).

Le microcontrôleur 15 vérifie aussi que la durée de test prédéterminée est bien suivie par une deuxième période de stabilité d'une deuxième durée prédéterminée de l'énergie consommée et de la tension réseau Vr (étape E4). La deuxième durée prédéterminée est égale à 3 secondes (consécutives).

Le microcontrôleur 15 vérifie donc que l'énergie consommée est stable (et à nouveau égale à E avec ici une tolérance de ±0,1%) et que la tension réseau Vr est stable sur les secondes 5, 6, 7 et égale à la tension Vr mesurée sur les secondes 1, 2, 3 avec ici une tolérance de ±0,1%.

Cette vérification permet de confirmer que l'énergie consommée « de base » pendant la quatrième seconde sans surplus d'énergie est bien toujours égale à E et que la tension réseau Vr est restée stable avant, pendant et après la mesure avec la même valeur de tension.

Si le microcontrôleur 15 ne détecte pas de deuxième période de stabilité, le procédé repasse à l'étape E2 ; la mesure réalisée à l'étape E3 n'est pas prise en compte.

Par contre, si la deuxième période de stabilité est bien détectée, le microcontrôleur 15 estime l'erreur de mesure du compteur 1 à partir du surplus d'énergie (étape E5) .

L'estimation de l'erreur de mesure est réalisée de la manière suivante.

Le microcontrôleur 15 estime le surplus d'énergie dû à la charge additionnelle :

$$Ec = Et - E.$$

Le microcontrôleur 15 compare le surplus d'énergie avec une valeur attendue. Cependant, cette valeur attendue dépend de la tension réseau Vr présente (possiblement légèrement différente de 230V).

Une calibration a été réalisée en usine, qui a permis de produire une valeur de référence de surplus d'énergie $Ec_{réf}$. Pour cela, on a mesuré sous 230V la valeur du courant traversant la résistance de test Rt, qui dépend de la valeur exacte de la résistance de test Rt, et on en a déduit la valeur du surplus d'énergie consommé pendant 1s sous 230V et dû à la résistance de test Rt. La valeur de référence de surplus d'énergie $Ec_{réf}$ est préenregistrée et mémorisée dans un paramètre de calibration usine stocké dans la mémoire 16.

Cette valeur a été obtenue en calibration pour une tension réseau Vr exactement égale à 230V.

Pour calculer l'erreur de mesure en opération, le microcontrôleur 15 calcule une valeur idéale de surplus d'énergie $Ec_{idéale}$, qui correspond au surplus d'énergie obtenu avec une précision parfaite. Le calcul de la valeur idéale de surplus d'énergie $Ec_{idéale}$ consiste à ramener, à la valeur efficace « en cours » de la tension réseau Vr, la valeur de référence de surplus d'énergie :

$$Ec_{idéale} = Ec_{réf} \times V_{RMS}/230,$$

où $V_{RMS}$ est la valeur efficace de la tension réseau Vr.

Le microcontrôleur 15 estime alors l'erreur de mesure en utilisant la formule :

$$Erreur = \frac{Ec - Ec_{idéale}}{Ec_{idéale}}.$$

Le microcontrôleur 15 vérifie alors si l'erreur de mesure se trouve dans la plage de précision requise (étape E6) .

Si c'est le cas, la variable N est réinitialisée à 0 (étape E7).

Le procédé passe alors dans une étape d'attente (étape E8), de durée par exemple égale à 24h, puis repasse à l'étape E2.

A l'étape E6, si l'erreur de mesure ne se trouve pas dans la plage de précision requise, la variable N est incrémentée (étape E9).

Le microcontrôleur 15 compare alors la valeur de N avec un seuil d'incrémentation prédéfini, ici égal à 3 (étape E10) .

Si N n'est pas égal à 3, le procédé passe dans une étape d'attente (étape E11), de durée par exemple égale à 24h, puis repasse à l'étape E2.

Lorsque N devient égal à 3, le microcontrôleur 15 produit un message d'alarme qui est envoyé par le compteur 1 au SI du distributeur d'énergie (étape E12).

Le procédé s'achève (étape E13).

Ainsi, l'anomalie d'erreur de mesure doit être détectée trois fois consécutivement pour provoquer l'envoi d'un message d'alarme.

On note que le surplus d'énergie Ec consommé pendant la 4ème seconde n'est pas pris en compte dans les calculs de cumul d'énergie qui permettront la facturation de l'abonné.

La résistance de test Rt a été calibrée en usine et ses caractéristiques sont parfaitement connues. La valeur de la résistance de test Rt est ici choisie égale à 4.7kΩ, ce qui a pour conséquence d'ajouter, lorsque le transistor 26 est passant, un courant de l'ordre de 50mA.

Le courant théorique ajouté avec une telle résistance de test est en effet égal à 230V/4.7kO = 48.936mA.

L'estimation de l'erreur de mesure est ici réalisée à courant faible (1A environ) : les périodes de stabilité correspondent donc à des périodes où le courant de phase Ip est faible.

On note que le circuit de test 25 comprend aussi une thermistance 28 connectée entre le transistor 26 et le conducteur de neutre 11. Plus précisément, le drain D du transistor 26 est relié au conducteur de neutre 11 via la thermistance 28. La thermistance 28 est du type CTP (Coefficient de Température Positif).

La thermistance 28 permet de répondre à des exigences de sécurité.

Il est possible qu'une panne maintienne passant de manière continue le transistor 26. Cette panne est par exemple une panne impactant la commande Cmde du microcontrôleur 15, ou bien une panne du transistor 26 lui-même. Dans ce cas, le courant circule de manière continue dans la résistance de test Rt, ce qui tend à augmenter sa température, de manière possiblement problématique pour les autres composants du compteur 1.

La thermistance 28 est positionnée à proximité de la résistance de test Rt de sorte qu'en cas de survenue d'une panne qui maintient passant de manière continue le transistor 26, une résistance résultante entre le conducteur de phase 10 et le conducteur de neutre 11 augmente avec une température de la résistance de test Rt.

La thermistance 28 est choisie de manière à présenter une résistance (presque) nulle à température ambiante. Ainsi, si le transistor 26 est maintenu passant de manière continue, l'échauffement anormal de la température de la résistance de test Rt augmente aussi et de manière significative la résistance de la thermistance 28, ce qui permet de diminuer le courant circulant dans la résistance de test Rt (et donc l'échauffement de celle-ci).

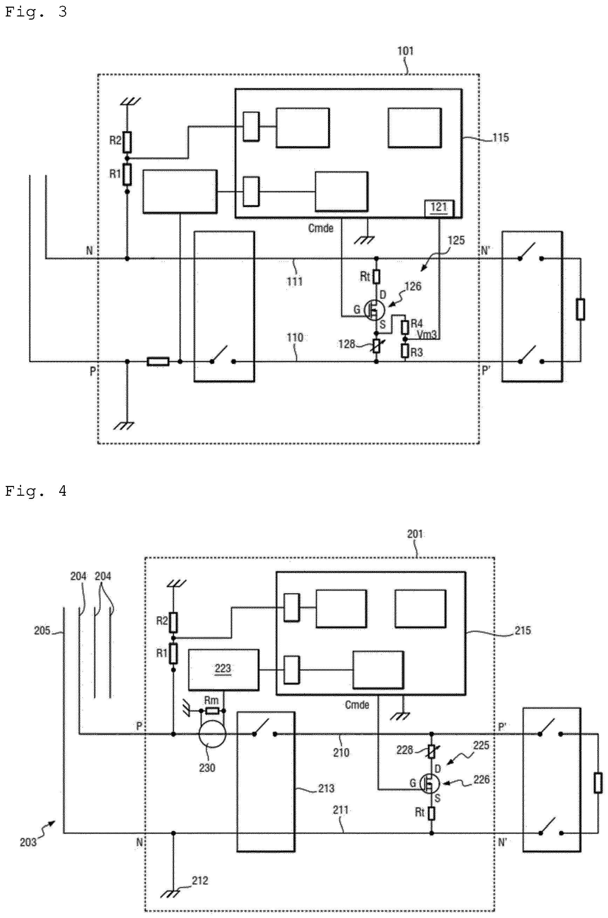

On décrit maintenant un compteur électrique selon un deuxième mode de réalisation de l'invention 101, en référence à la figure 3.

Le compteur 101 est à nouveau un compteur monophasé.

Cette fois, la résistance de test Rt comprend une première borne reliée au conducteur de neutre 111.

Le transistor 126 comprend une première borne reliée à une deuxième borne de la résistance de test Rt, et une deuxième borne reliée au conducteur de phase 110. La première borne du transistor 126 est son drain D et la deuxième borne du transistor 126 est sa source S. Le transistor 126 est à nouveau piloté par le microcontrôleur 115 qui produit une commande Cmde sur la grille G du transistor 126.

La thermistance 128 est connectée entre le transistor 126 et le conducteur de phase 110. Plus précisément, la source S du transistor 126 est reliée au conducteur de phase 110 via la thermistance 128.

Le circuit de test 125 comprend de plus des composants de surveillance permettant de surveiller que le composant de connexion, c'est-à-dire le transistor 126, a répondu de manière correcte à la commande Cmde produite par le microcontrôleur 115.

Les composants de surveillance comprennent un troisième CAN 121 intégré dans le microcontrôleur 115, une première résistance de surveillance R3 ayant une première borne reliée au conducteur de phase 110, une deuxième résistance de surveillance R4 ayant une première borne reliée à la source S du transistor 126. La deuxième borne de la première résistance de surveillance R3 et la deuxième borne de la deuxième résistance de surveillance R4 sont reliées entre elles et à une entrée du microcontrôleur 115 à laquelle est reliée une entrée du troisième CAN 121.

Ici, la première résistance de surveillance R3 a la même valeur de résistance que la deuxième résistance de mesure R2 et la deuxième résistance de surveillance R4 a la même valeur de résistance que la première résistance de mesure R1.

La première résistance de surveillance R3 et la deuxième résistance de surveillance R4 forment un pont diviseur de tension.

Le pont diviseur de tension R3, R4 permet de produire une tension Vm3 qui est une tension image de la tension présente sur la source S du transistor 126.

Le pont diviseur de tension R3, R4 permet d'obtenir une tension Vm3 dont le niveau est acceptable à l'entrée du troisième CAN 121.

Les composants de surveillance permettent de vérifier que la commande Cmde sur la grille G du transistor 126 est bien effective. Les composants de surveillance permettent notamment de vérifier qu'un courant circulant dans la résistance de test Rt est nul lorsque le microcontrôleur 115 a piloté le transistor 126 pour que celui-ci place la résistance de test Rt dans la configuration de déconnexion.

En effet, lorsque le microcontrôleur 115 commande une ouverture du transistor 126 (qui passe dans l'état bloqué), la tension Vm3 lue par le troisième CAN 121, en l'absence d'anomalie de la commande Cmde vers le transistor 126, est normalement égale à 0V.

Si le troisième CAN 121 lit une tension de surveillance significative, cela signifie qu'un échauffement de la résistance de test Rt s'est produit, provoquant une augmentation de la thermistance 128, et donc qu'un courant significatif traverse la résistance de test Rt alors que cela ne devrait pas être le cas si la commande Cmde avait bien ouvert le transistor 126. Il y a donc une panne qui impacte la commande Cmde vers le transistor 115.

Ainsi, préalablement à la mise en oeuvre du procédé d'évaluation de l'erreur de mesure, le microcontrôleur 115 utilise les composants de surveillance pour vérifier que la commande Cmde du transistor 126 fonctionne correctement.

Pour effectuer cette vérification, le microcontrôleur 115 produit une commande Cmde qui est un niveau de tension bas censé commander un état bloqué du transistor 126. Le microcontrôleur 115 compare alors la tension Vm3 mesurée par le troisième CAN 121 avec un seuil de surveillance prédéfini, et détecte une panne de la commande Cmde si la tension Vm3 est supérieure au seuil de surveillance prédéfini.

Le procédé d'évaluation de l'erreur de mesure n'est mis en oeuvre que si le microcontrôleur 115 n'a pas détecté de panne de la commande Cmde. Si le microcontrôleur 115 détecte une panne, le microcontrôleur 115 produit un message d'alarme qui est envoyé par le compteur 1 au SI du distributeur d'énergie.

On décrit maintenant un compteur électrique selon un deuxième mode de réalisation de l'invention 201, en référence à la figure 4.

Le compteur 201 est cette fois un compteur triphasé.

Le compteur 201 comprend une pluralité de conducteurs de phase 210, reliés chacun à l'une des phases 204 du réseau de distribution 203.

Un circuit de test 225 distinct est associé à chacune des phases 204 du réseau de distribution 203.

Chaque circuit de test 225 comprend un composant de test et un composant de connexion, en l'occurrence une résistance de test Rt et un transistor 226.

Ici, la résistance de test Rt comprend une première borne reliée au conducteur de neutre 211.

Le transistor 226 comprend une première borne reliée à une deuxième borne de la résistance de test Rt, et une deuxième borne reliée au conducteur de phase 210. La première borne du transistor 226 est sa source S et la deuxième borne du transistor 226 est son drain D. Le transistor 226 est piloté par le microcontrôleur 215 qui produit une commande Cmde sur la grille G du transistor 226.

La thermistance 228 est connectée entre le transistor 226 et le conducteur de phase 210. Plus précisément, le drain D du transistor 226 est relié au conducteur de phase 210 via la thermistance 228.

Cette fois, le capteur de courant n'est plus un *shunt,* mais un tore 230 monté sur le conducteur de phase 210 en amont de l'organe de coupure 213. Une résistance de mesure Rm est montée entre les bornes de sortie du tore 230. La chaîne de mesure de courant 223 est reliée à l'une des bornes de la résistance de mesure Rm, l'autre des bornes de la résistance de mesure Rm étant reliée à la masse électrique 212 du compteur 201.

L'estimation de l'erreur de mesure est réalisée, pour chacune des phases 204, de la même manière que pour les compteurs 1 et 101.

On note que, de préférence, l'erreur de mesure est estimée pour chacune des phases 204 l'une après l'autre et non simultanément. Le microcontrôleur 215 comporte par conséquent de préférence, pour appliquer les commandes Cmde, trois sorties distinctes reliées chacune à la grille G du transistor 226 de l'un des circuits de test 225.

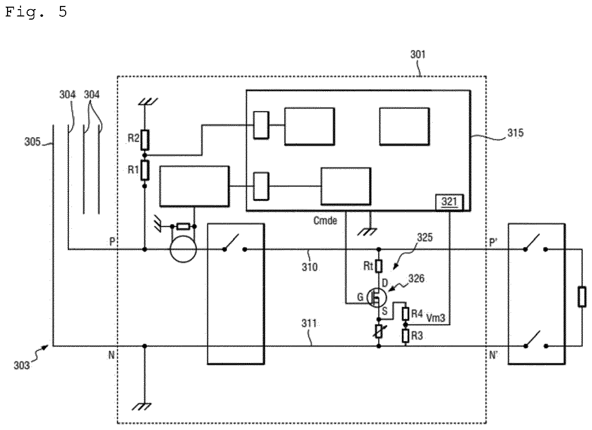

Avantageusement, en référence à la figure 5, chaque phase 304 du réseau de distribution 303 à laquelle est relié le compteur triphasé 301 est associée à un circuit de test 325 qui comprend en outre des composants de surveillance semblables à ceux de la figure 3.

Les composants de surveillance permettent de surveiller que le composant de connexion, c'est-à-dire le transistor 326, a répondu de manière correcte à la commande Cmde produite par le microcontrôleur 315.

Les composants de surveillance comprennent à nouveau un troisième CAN 321 intégré dans le microcontrôleur 315, une première résistance de surveillance R3 ayant une première borne reliée au conducteur de neutre 311, une deuxième résistance de surveillance R4 ayant une première borne reliée à la source S du transistor 326. La deuxième borne de la première résistance de surveillance R3 et la deuxième borne de la deuxième résistance de surveillance R4 sont reliées entre elles et à une entrée du microcontrôleur 315 à laquelle est reliée une entrée du troisième CAN 321.

A nouveau, la deuxième résistance de surveillance R4 a la même valeur de résistance que la première résistance de mesure R1 et la première résistance de surveillance R3 a la même valeur de résistance que la deuxième résistance de mesure R2.

On a vu plus haut que l'estimation de l'erreur de mesure est réalisée à courant faible. Cependant, et quel que soit le compteur (monophasé, triphasé), il est possible d'évaluer l'erreur de mesure quel que soit le niveau du courant de phase Ip.

Ainsi, pour chaque phase, le compteur peut comprendre au moins un premier circuit de test et un deuxième circuit de test associés à ladite phase, le microcontrôleur évaluant l'erreur de mesure en utilisant le premier circuit de test lorsque le courant de phase Ip circulant sur le conducteur de phase relié à ladite phase est inférieur à un seuil de courant prédéfini, et en utilisant le deuxième circuit de test lorsque le courant de phase est supérieur au seuil de courant prédéfini.

Le compteur peut notamment comporter trois circuits de test par phase : un premier circuit de test dédié à la vérification à faible courant (1A environ) et comprenant une résistance de test Rt, un deuxième circuit de test dédié à la vérification à moyen courant (5A à 20A) et comprenant une résistance de test Rmoyen, et un troisième circuit de test dédié à la vérification à fort courant (supérieur à 40A) et comprenant une résistance de test Rfort. Les résistances de test Rt, Rmoyen et Rfort ont possiblement des puissances maximales admissibles différentes.

Pour chaque phase, le compteur comporte donc trois circuits de test comprenant chacun une résistance de test, un transistor et une thermistance, avec trois commandes Cmde séparées générées par le microcontrôleur.

Le microcontrôleur utilise alors deux seuils de courant prédéfinis pour sélectionner le circuit de test utilisé. Le premier seuil de courant, permettant de choisir entre le premier circuit de test et le deuxième circuit de test, est par exemple compris entre 2A et 4A, et le deuxième seuil de courant, permettant de choisir entre le deuxième circuit de test et le troisième circuit de test, est par exemple compris entre 25A et 35A.

Chacun des compteurs qui a été décrit intègre en outre un capteur de température qui mesure la température ambiante régnant dans le coffret du compteur.

Les mesures produites par le capteur de température peuvent être utilisées pour estimer la température de la résistance de test Rt. Le microcontrôleur connaît la variation de la résistance de test Rt en fonction de sa température (courbe donnée par le fournisseur).

Le microcontrôleur peut donc acquérir les mesures de température ambiante produites par le capteur de température, estimer une valeur corrigée en température de la résistance de test à partir de ces mesures, et utiliser ladite valeur corrigée en température de manière à améliorer une précision de la mesure du surplus d'énergie et donc de l'erreur de mesure du compteur.

Avantageusement, le procédé d'évaluation de l'erreur de mesure du compteur est mis en oeuvre la nuit, là où la température ambiante est censée être la plus faible, ce qui permet d'assurer que l'échauffement de la résistance de test pendant le test est minimal.

Bien entendu, l'invention n'est pas limitée aux modes de réalisation décrits mais englobe toute variante entrant dans le champ de l'invention telle que définie par les revendications.

L'invention peut être mise en œuvre avec un compteur électrique monophasé, ou bien multiphasé et relié à un nombre de phases quelconque.

L'architecture du compteur pourrait bien sûr être différente de celle décrite ici.

On a décrit que deux ou trois CANs sont intégrés dans le microcontrôleur. Il est cependant possible d'utiliser un unique CAN intégré dans le microcontrôleur. Le microcontrôleur comprend alors une première entrée reliée au pont diviseur de tension R1, R2 des composants métrologiques, une deuxième entrée reliée à la chaîne de mesure de courant, et éventuellement une troisième entrée reliée au pont diviseur de tension R3, R4 des composants de surveillance.

Ces entrées du microcontrôleur sont reliées au CAN, qui intègre un multiplexeur ayant (au moins) deux ou trois entrées reliées respectivement à la première entrée, la deuxième entrée et éventuellement la troisième entrée, ainsi qu'une sortie reliée au coeur de conversion du CAN.

Le ou les CANs peuvent aussi être un ou des CANs externes au microcontrôleur.

Le microcontrôleur dans lequel est mise en oeuvre l'invention n'est pas nécessairement le microcontrôleur métrologique mais pourrait être un composant distinct.

Le composant de traitement dans lequel est mise en oeuvre l'invention n'est pas nécessairement un microcontrôleur, mais pourrait être un composant différent, et par exemple un processeur classique, un DSP (pour *Digital Signal Processor,* que l'on peut traduire par « processeur de signal numérique »), ou bien un circuit logique programmable tel qu'un FPGA (pour *Field Programmable Gate Arrays*) ou un ASIC (pour *Application Spécifie Integrated Circuit*).

Le composant de test n'est pas nécessairement une (seule) résistance, mais peut comprendre un ou plusieurs composants quelconques pouvant former une charge additionnelle (condensateur, inductance, etc.). Le composant de connexion peut être tout type de composant susceptible de placer le composant de test dans la configuration de connexion ou dans la configuration de déconnexion (et par exemple un autre type de transistor).

Le composant de traitement et le composant de connexion pourraient être un seul et même composant.

**Revendications**

1. Compteur électrique (1) agencé pour mesurer une énergie consommée fournie à une installation (2) par un réseau de distribution (3) comprenant une phase (4) et un neutre (5), le compteur électrique comportant :

    - un conducteur de phase (10) et un conducteur de neutre (11) agencés pour être reliés respectivement à la phase et au neutre ;
    - un circuit de test (25) comprenant un composant de test (Rt) et un composant de connexion (26) agencé pour placer sélectivement le composant de test dans une configuration de connexion, dans laquelle le composant de test est connecté au conducteur de phase et au conducteur de neutre parallèlement à l'installation, de manière à former une charge additionnelle, et une configuration de déconnexion, dans laquelle le composant de test est déconnecté du conducteur de phase et/ou du conducteur de neutre ;
    - un composant de traitement (15) agencé pour piloter le composant de connexion de sorte que celui-ci place le composant de test dans la configuration de connexion pendant une durée de test prédéterminée, **caractérisé en ce que** le composant de traitement (15) est agencé pour mesurer un surplus d'énergie consommé pendant la durée de test prédéterminée et dû à la charge additionnelle, et pour estimer une erreur de mesure du compteur électrique à partir du surplus d'énergie.

2. Compteur électrique selon la revendication 1, dans lequel le composant de traitement (15) est agencé pour tenter de détecter une première période de stabilité d'une première durée prédéterminée de l'énergie consommée et d'une tension réseau (Vr) entre la phase (4) et le neutre (5), et pour piloter le composant de connexion de manière à placer le composant de test dans la configuration de connexion seulement après avoir détecté la première période de stabilité.

3. Compteur électrique selon la revendication 2, dans lequel le composant de traitement (15) est agencé pour vérifier que la durée de test prédéterminée est bien suivie par une deuxième période de stabilité d'une deuxième durée prédéterminée de l'énergie consommée et de la tension réseau (Vr), et pour estimer l'erreur de mesure seulement si la deuxième période de stabilité est détectée.

4. Compteur électrique selon l'une des revendications précédentes, dans lequel le composant de traitement (15) est agencé pour mesurer la tension réseau (Vr), pour calculer une valeur idéale de surplus d'énergie en ramenant à la tension réseau (Vr) une valeur de référence de surplus d'énergie préenregistrée, et pour estimer l'erreur de mesure à partir du surplus d'énergie et de la valeur idéale de surplus d'énergie.

5. Compteur électrique selon l'une des revendications précédentes, dans lequel le composant de test comprend une première borne reliée à un premier conducteur parmi le conducteur de phase (10) et le conducteur de neutre (11), et dans lequel le composant de connexion a une fonction d'interrupteur et comprend une première borne reliée à une deuxième borne du composant de test et une deuxième borne reliée à un deuxième conducteur parmi le conducteur de phase et le conducteur de neutre.

6. Compteur électrique selon la revendication 5, dans lequel la deuxième borne du composant de connexion est reliée au deuxième conducteur via une thermistance (28) de sorte qu'en cas de survenue d'une panne qui maintient passant de manière continue le composant de connexion, une résistance résultante entre le conducteur de phase (10) et le conducteur de neutre (11) augmente avec une température du composant de test.

7. Compteur électrique selon l'une des revendications précédentes, comprenant en outre des composants de surveillance agencés pour vérifier qu'un courant circulant dans le composant de test est nul lorsque le composant de traitement (15) a piloté le composant de connexion pour que celui-ci place le composant de test dans la configuration de déconnexion.

8. Compteur électrique selon les revendications 6 et 7, dans lequel les composants de surveillance comprennent un convertisseur analogique numérique (121) et un pont diviseur de tension (R3, R4) agencé pour produire une tension image d'une tension présente sur la deuxième borne du composant de connexion.

9. Compteur électrique selon l'une des revendications précédentes, comprenant en outre un capteur de température agencé pour mesurer une température ambiante régnant à l'intérieur du compteur (1), le composant de traitement (15) étant agencé pour acquérir des mesures de la température ambiante, pour estimer une valeur corrigée en température du composant de test et pour utiliser ladite valeur corrigée en température de manière à améliorer une précision de la mesure du surplus d'énergie et donc de l'erreur de mesure du compteur électrique.

10. Compteur électrique selon l'une des revendications précédentes, comprenant au moins un premier circuit de test et un deuxième circuit de test associés à ladite phase, le composant de traitement (15) étant agencé pour évaluer l'erreur de mesure du compteur électrique en utilisant le premier circuit de test lorsqu'un courant de phase (Ip) circulant sur la phase (4) est inférieur à un seuil de courant prédéfini, et en utilisant le deuxième circuit de test lorsque le courant de phase est supérieur au seuil de courant prédéfini.

11. Compteur électrique selon l'une des revendications précédentes, le compteur électrique étant un compteur multiphasé et le réseau de distribution comprenant une pluralité de phases, le compteur électrique comprenant au moins un circuit de test associé à chaque phase.

12. Compteur électrique selon l'une des revendications précédentes, le composant de test étant une résistance (Rt).

13. Compteur électrique selon l'une des revendications précédentes, le composant de connexion étant un transistor MOSFET (26).

14. Compteur électrique selon l'une des revendications précédentes, dans lequel le composant de traitement (15) est aussi agencé pour mesurer un courant de phase (Ip) circulant sur la phase (4), une tension réseau (Vr) entre la phase et le neutre, et l'énergie consommée par l'installation.

15. Procédé d'évaluation de l'erreur de mesure d'un compteur électrique (1) selon l'une des revendications précédentes, comprenant les étapes de :

   - piloter le composant de connexion de sorte que celui-ci place le composant de test dans la configuration de connexion pendant une durée de test prédéterminée ; le procédé étant **caractérisé en ce qu'**il comprend les étapes de :
   - mesurer le surplus d'énergie consommé pendant la durée de test prédéterminée et dû à la charge additionnelle ;
   - évaluer l'erreur de mesure du compteur électrique à partir du surplus d'énergie.

16. Procédé d'évaluation de l'erreur de mesure selon la revendication 15, comprenant de plus l'étape de tenter de détecter une première période de stabilité de l'énergie consommée et d'une tension réseau (Vr) entre la phase (4) et le neutre (5), et de placer le composant de test dans la configuration de connexion seulement après avoir détecté la première période de stabilité.

17. Procédé d'évaluation de l'erreur de mesure selon la revendication 16, comprenant de plus l'étape de tenter de détecter une deuxième période de stabilité de l'énergie consommée et de la tension réseau après la durée de test prédéterminée, et d'estimer l'erreur de mesure seulement si la deuxième période de stabilité est détectée.

18. Procédé d'évaluation de l'erreur de mesure selon l'une des revendications 15 à 17, comprenant en outre l'étape de vérifier si l'erreur de mesure appartient bien à une plage de précision requise, d'incrémenter une variable si ce n'est pas le cas, puis de répéter les étapes précédentes et, lorsque la variable devient égale à un seuil d'incrémentation prédéfini, de produire une alarme.

19. Programme d'ordinateur comprenant des instructions qui conduisent le composant de traitement (15) du compteur électrique (1) selon l'une des revendications 1 à 14 à exécuter les étapes du procédé d'évaluation de l'erreur de mesure selon l'une des revendications 15 à 18.

**20.** Support d'enregistrement lisible par ordinateur, sur lequel est enregistré le programme d'ordinateur selon la revendication 19.

**Patentansprüche**

**1.** Stromzähler (1), der ausgebildet ist, eine verbrauchte Energie zu messen, die an eine Anlage (2) durch ein Verteilungsnetz (3) geliefert wird, das eine Phasenleitung (4) und eine Neutralleitung (5) umfasst, wobei der Stromzähler umfasst:

- einen Phasenleiter (10) und einen Neutralleiter (11), die ausgebildet sind, mit der Phasenleitung bzw. der Neutralleitung verbunden zu werden;
- eine Testschaltung (25), die eine Testkomponente (Rt) und eine Verbindungskomponente (26) umfasst, die ausgebildet ist, die Testkomponente selektiv in eine Verbindungskonfiguration zu bringen, in der die Testkomponente mit dem Phasenleiter und mit dem Neutralleiter parallel zur Anlage verbunden ist, um eine zusätzliche Last zu bilden, und in eine Trennungskonfiguration, in der die Testkomponente von dem Phasenleiter und/oder dem Neutralleiter getrennt ist;
- eine Verarbeitungskomponente, die ausgebildet ist, die Verbindungskomponente derart zu steuern, dass diese die Testkomponente für eine vorbestimmte Testdauer in die Verbindungskonfiguration bringt, **dadurch gekennzeichnet, dass** die Verarbeitungskomponente (15) ausgebildet ist, einen Energieüberschuss zu messen, der während der vorbestimmten Testdauer verbraucht wird und auf die zusätzliche Last zurückzuführen ist, und einen Messfehler des Stromzählers anhand des Energieüberschusses zu schätzen.

**2.** Stromzähler nach Anspruch 1, bei dem die Verarbeitungskomponente (15) ausgebildet ist, zu versuchen, eine erste Periode der Stabilität einer ersten vorbestimmten Dauer der verbrauchten Energie und einer Netzspannung (Vr) zwischen der Phasenleitung (4) und der Neutralleitung (5) zu erfassen, und die Verbindungskomponente zu steuern, um die Testkomponente erst nach Erfassung der ersten Stabilitätsperiode in die Verbindungskonfiguration zu bringen.

**3.** Stromzähler nach Anspruch 2, bei dem die Verarbeitungskomponente (15) ausgebildet ist, zu verifizieren, ob auf die vorbestimmte Testdauer eine zweite Periode der Stabilität einer zweiten vorbestimmten Dauer der verbrauchten Energie und der Netzspannung (Vr) folgt, und den Messfehler nur dann zu schätzen, wenn die zweite Stabilitätsperiode erfasst wird.

**4.** Stromzähler nach einem der vorhergehenden Ansprüche, bei dem die Verarbeitungskomponente (15) ausgebildet ist, die Netzspannung (Vr) zu messen, einen Idealwert für den Energieüberschuss zu berechnen, indem ein vorgespeicherter Energieüberschuss-Referenzwert auf die Netzspannung (Vr) gebracht wird, und den Messfehler anhand des Energieüberschusses und des Idealwerts für den Energieüberschuss zu schätzen.

**5.** Stromzähler nach einem der vorhergehenden Ansprüche, bei dem die Testkomponente eine erste Anschlussklemme umfasst, die mit einem ersten Leiter unter dem Phasenleiter (10) und dem Neutralleiter (11) verbunden ist, und bei dem die Verbindungskomponente eine Unterbrecherfunktion hat und eine erste Anschlussklemme umfasst, die mit einer zweiten Anschlussklemme der Testkomponente verbunden ist, und eine zweite Anschlussklemme, die mit einem zweiten Leiter unter dem Phasenleiter und dem Neutralleiter verbunden ist.

**6.** Stromzähler nach Anspruch 5, bei dem die zweite Anschlussklemme der Verbindungskomponente mit dem zweiten Leiter über einen Thermistor (28) verbunden ist, derart, dass im Falle des Auftretens einer Panne, die die Verbindungskomponente kontinuierlich leitend hält, ein Widerstand, der zwischen dem Phasenleiter (10) und dem Neutralleiter (11) resultiert, mit einer Temperatur der Testkomponente zunimmt.

**7.** Stromzähler nach einem der vorhergehenden Ansprüche, ferner umfassend Überwachungskomponenten, die ausgebildet sind, zu verifizieren, ob ein Strom, der in der Testkomponente fließt, Null ist, wenn die Verarbeitungskomponente (15) die Verbindungskomponente so gesteuert hat, dass diese die Testkomponente in die Trennungskonfiguration bringt.

**8.** Stromzähler nach den Ansprüchen 6 und 7, bei dem die Überwachungskomponenten einen Analog-Digital-Wandler (121) und eine Spannungsteilerbrücke (R3, R4) umfassen, die ausgebildet ist, eine Spannung, die ein Bild einer an der zweiten Anschlussklemme der Verbindungskomponente vorhandenen Spannung ist, zu erzeugen.

**9.** Stromzähler nach einem der vorhergehenden Ansprüche, ferner umfassend einen Temperatursensor, der ausgebildet ist, eine Umgebungstemperatur zu messen, die im Inneren des Zählers (1) herrscht, wobei die Verarbeitungskomponente (15) ausgebildet ist, Messungen der Umgebungstemperatur zu erfassen, einen temperaturkorrigierten Wert der Testkomponente zu schätzen und den genannten temperaturkorrigierten Wert zu verwenden, um eine Genauigkeit der Messung des Energieüberschusses und folglich des Messfehlers des Stromzählers zu verbessern.

10. Stromzähler nach einem der vorhergehenden Ansprüche, umfassend mindestens eine erste Testschaltung und eine zweite Testschaltung, die mit der genannten Phase verbunden sind, wobei die Verarbeitungskomponente (15) ausgebildet ist, den Messfehler des Stromzählers zu evaluieren, indem die erste Testschaltung verwendet wird, wenn ein Phasenstrom (Ip), der auf der Phase (4) fließt, kleiner als ein vordefinierter Stromschwellenwert ist, und indem die zweite Testschaltung verwendet wird, wenn der Phasenstrom größer als der vordefinierte Stromschwellenwert ist.

11. Stromzähler nach einem der vorhergehenden Ansprüche, wobei der Stromzähler ein Mehrphasenzähler ist und das Verteilungsnetz eine Vielzahl von Phasen umfasst, wobei der Stromzähler mindestens eine Testschaltung umfasst, die mit jeder Phase verbunden ist.

12. Stromzähler nach einem der vorhergehenden Ansprüche, wobei die Testkomponente ein Widerstand (Rt) ist.

13. Stromzähler nach einem der vorhergehenden Ansprüche, wobei die Verbindungskomponente ein MOSFET-Transistor (26) ist.

14. Stromzähler nach einem der vorhergehenden Ansprüche, bei dem die Verarbeitungskomponente (15) ebenso ausgebildet ist, einen Phasenstrom (Ip) zu messen, der auf der Phase (4) fließt, eine Netzspannung (Vr) zwischen der Phasenleitung und der Neutralleitung und die von der Anlage verbrauchte Energie.

15. Verfahren zur Evaluierung des Messfehlers eines Stromzählers (1) nach einem der vorhergehenden Ansprüche, umfassend die Schritte:

- Steuern der Verbindungskomponente, derart, dass diese die Testkomponente für eine vorbestimmte Testdauer in die Verbindungskonfiguration bringt; wobei das Verfahren **dadurch gekennzeichnet ist, dass** es die Schritte umfasst:
- Messen des Energieüberschusses, der während der vorbestimmten Testdauer verbraucht wird und auf die zusätzliche Last zurückzuführen ist;
- Evaluieren des Messfehlers des Stromzählers anhand des Energieüberschusses.

16. Verfahren zur Evaluierung des Messfehlers nach Anspruch 15, ferner umfassend den Schritt des Versuchens, eine erste Periode der Stabilität der verbrauchten Energie und einer Netzspannung (Vr) zwischen der Phasenleitung (4) und der Neutralleitung (5) zu erfassen, und des Bringens der Testkomponente erst nach Erfassung der ersten Stabilitätsperiode in die Verbindungskonfiguration.

17. Verfahren zum Evaluieren des Messfehlers nach Anspruch 16, ferner umfassend den Schritt des Versuchens, eine zweite Periode der Stabilität der verbrauchten Energie und der Netzspannung nach der vorbestimmten Testdauer zu erfassen, und des Schätzens des Messfehlers nur, wenn die zweite Stabilitätsperiode erfasst wird.

18. Verfahren zum Evaluieren des Messfehlers nach einem der Ansprüche 15 bis 17, ferner umfassend den Schritt des Verifizierens, ob der Messfehler zu einem erforderlichen Genauigkeitsbereich gehört, des Inkrementierens einer Variable, wenn dies nicht der Fall ist, und dann des Wiederholens der vorhergehenden Schritte, und, wenn die Variable gleich einem vordefinierten Inkrementierungsschwellenwert wird, des Erzeugens eines Alarms.

19. Computerprogramm, umfassend Anweisungen, die die Verarbeitungskomponente (15) des Stromzählers (1) nach einem der Ansprüche 1 bis 14 dazu veranlassen, die Schritte des Verfahrens zum Evaluieren des Messfehlers nach einem der Ansprüche 15 bis 18 auszuführen.

20. Computerlesbarer Aufzeichnungsträger, auf dem das Computerprogramm nach Anspruch 19 gespeichert ist.

**Claims**

1. An electricity meter (1) arranged to measure the consumption of energy supplied to an installation (2) by a distribution network (3) comprising a phase line (4) and a neutral line (5), the electricity meter comprising:

· a phase conductor (10) and a neutral conductor (11) arranged to be connected respectively to the phase line and to the neutral line;
· a test circuit (25) comprising a test component (Rt) and a connection component (26) arranged to place the test component selectively in a connected configuration, in which the test component is connected to the phase conductor and to the neutral conductor in parallel with the installation so as to form an additional load, and a disconnected configuration in which the test component is disconnected from the phase conductor and/or from the neutral conductor;

· a processor component (15) arranged to control the connection component in such a manner that it places the test component in the connected configuration during a predetermined test duration, **characterized in that** the processor component (15) is arranged to measure surplus energy consumed during the predetermined test duration and due to the additional load, and to estimate measurement error of the electricity meter from the surplus energy.

2. An electricity meter according to claim 1, wherein the processor component (15) is arranged to attempt to detect stability both in energy consumption and in network voltage (Vr) between the phase line (4) and the neutral line (5) over a first period of stability having a first predetermined duration, and in order to control the connection component in such a manner as to place the test component in the connected configuration only after the first period of stability has been detected.

3. An electricity meter according to claim 2, wherein the processor component (15) is arranged to verify that the predetermined test duration is followed by stability both in energy consumption and in network voltage (Vr) over a second period of stability having a second duration, and to estimate measurement error only if the second period of stability is detected.

4. An electricity meter according to any preceding claim, wherein the processor component (15) is arranged to measure network voltage (Vr), to calculate an ideal value for the surplus energy by relating a pre-recorded reference value for surplus energy to the network voltage (Vr), and to estimate measurement error from the surplus energy and from the ideal value for surplus energy.

5. An electricity meter according to any preceding claim, wherein the test component has a first terminal connected to a first conductor selected from the phase conductor (10) and the neutral conductor (11), and wherein the connection component has a switch function and comprises a first terminal connected to a second terminal of the test component and a second terminal connected to a second conductor selected from the phase conductor and the neutral conductor.

6. An electricity meter according to claim 5, wherein the second terminal of the connection component is connected to the second conductor via a thermistor (28) such that in the event of a failure occurring that causes the connection component to be maintained continuously conductive, a resistance that results between the phase conductor (10) and the neutral conductor (11) increases with increasing temperature of the test component.

7. An electricity meter according to any preceding claim, further comprising monitoring components arranged to verify that current flowing in the test component is zero when the processor component (15) has controlled the connection component so that it places the test component of the disconnected configuration.

8. An electricity meter according to claims 6 and 7, wherein the monitoring components comprise an analog-to-digital converter (121) and a voltage divider bridge (R3, R4) arranged to produce a voltage that is an image of the voltage present at the second terminal of the connection component.

9. An electricity meter according to any preceding claim, further including a temperature sensor arranged to measure ambient temperature inside the meter (1), the processor component (15) being arranged to acquire measurements of the ambient temperature, to estimate a temperature-corrected value for the test component and to use said temperature-corrected value so as to improve the accuracy with which surplus energy is measured, and thus improve the accuracy with which measurement error of the electricity meter is estimated.

10. An electricity meter according to any preceding claim, comprising at least a first test circuit and a second test circuit associated with said phase line, the processor component (15) being arranged to evaluate measurement error of the electricity meter by using the first test circuit when phase current (Ip) flowing in the phase line (4) is less than a predefined current threshold, and using the second test circuit when the phase current is greater than the predefined current threshold.

11. An electricity meter according to any preceding claim, the electricity meter being a multi-phase meter and the distribution network having a plurality of phase lines, the electricity meter having at least one respective test circuit associated with each phase line.

12. An electricity meter according to any preceding claim, the test component being a resistor (Rt).

13. An electricity meter according to any preceding claim, the connection component being a MOSFET (26).

14. An electricity meter according to any preceding claim, wherein the processor component (15) is also arranged to measure phase current (Ip) flowing in the phase line (4), network voltage (Vr) between the phase line and the neutral line, and energy consumption by the installation.

15. A method of evaluating the measurement error of an electricity meter (1) according to any preceding claim, the method comprising the steps of:

· controlling the connection component so that it places the test component in the connected configuration during a predetermined test duration, the method being **characterized in that** it comprises the steps of :

· during the predetermined test duration, measuring surplus energy consumption due to the additional load;
· evaluating the measurement error of the electricity meter from the surplus energy.

16. A method of evaluating measurement error according to claim 15, further comprising a step of detecting a first period of stability both in energy consumption and in network voltage (Vr) between the phase line (4) and the neutral line (5), and to place the test component in the connected configuration only after a first period of stability has been detected.

17. A method of evaluating measurement error according to claim 16, further comprising, after the predetermined test duration, the step of attempting to detect a second period of stability both in energy consumption and also in network voltage, and of estimating measurement error only if the second period of stability is detected.

18. A method of evaluating measurement error according to any one of claims 15 to 17, further comprising the step of verifying whether the measurement error lies within a required accuracy range, of incrementing a variable if it does not, and then repeating the preceding steps, and producing an alarm when the variable becomes equal to a predefined incrementation threshold.

19. Computer program comprising instructions which drive the processor component (15) of the electricity meter (1) according to one of claims 1 to 14 to execute the steps of the method of evaluating measurement error according to one of claims 15 to 18.

20. A computer-readable storage medium storing the computer program according to claim 19.

Fig. 1

Fig. 2

Fig. 3

Fig. 4

Fig. 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2904410 B1
- EP 0092303 B1
- WO 2014027318 A1